# EUROPÄISCHE PATENTSCHRIFT

(11) **EP 3 496 124 B1**
(45) Veröffentlichungstag und Bekanntmachung des Hinweises auf die Patenterteilung: **20.05.2020**
(21) Anmeldenummer: 18199459.1
(22) Anmeldetag: 09.10.2018
(51) Int. Cl.: H01H 13/85, G06F 3/01, G06F 3/041, G06F 3/044, H01H 3/00

(54) **VERFAHREN ZUR ANSTEUERUNG EINER BEDIENVORRICHTUNG FÜR EIN KRAFTFAHRZEUG SOWIE BEDIENVORRICHTUNG**
METHOD FOR CONTROLLING AN OPERATING DEVICE FOR A MOTOR VEHICLE AND OPERATING DEVICE
PROCÉDÉ DE COMMANDE D'UN DISPOSITIF DE FONCTIONNEMENT POUR UN VÉHICULE AUTOMOBILE AINSI QUE DISPOSITIF DE FONCTIONNEMENT

(30) Priorität: 27.11.2017 DE 102017221121
(43) Veröffentlichungstag der Anmeldung: 12.06.2019
(73) Patentinhaber: VOLKSWAGEN AKTIENGESELLSCHAFT, 38440 Wolfsburg (DE)
(72) Erfinder: Meierling, Klaus, 44879 Bochum (DE); Petter, Niels, 45133 Essen (DE)

(56) Entgegenhaltungen:
- WO-A2-01/95358
- DE-A1-102014 219 316
- DE-A1-102015 007 822
- DE-A1-102015 009 314
- DE-A1-102015 015 417
- US-A1- 2012 092 263

## Beschreibung

Die Erfindung betrifft ein Verfahren zur Ansteuerung einer Bedienvorrichtung für ein Kraftfahrzeug mit den Merkmalen vom Oberbegriff des Patentanspruchs 1. Die Erfindung betrifft auch eine Bedienvorrichtung zur Durchführung des Verfahrens.

Die Merkmale vom Oberbegriff des Verfahrens- und auch vom Oberbegriff des unabhängigen Sachanspruchs gehen aus der US2014/0125470 A1 hervor. Konkret ist eine Bedienungsvorrichtung offenbart, welche ein von einem Gehäuse umrahmtes Bedienelement mit einer Bedienoberfläche aufweist. Unter dem Bedienelement ist, durch eine Abstandsscheibe beabstandet, eine piezoelektrische Membran angeordnet, welche durch ein elektrisch ansteuerbares Piezoelement antreibbar ist. Vorgespannte Federn verbinden das Bedienelement mit einem Boden des Gehäuses und halten dies federelastisch in seiner Ausgangslage. Zur Ausgabe einer haptischen Rückmeldung an einen Bediener wird das Piezoelement elektrisch angeregt und die piezoelektrische Membran verformt. Dies erfolgt in der Weise, dass das Bedienelement eine oszillierende Bewegung durchführt.

In der DE 10 2015 007 822 A1 wird eine Bedienvorrichtung für ein Kraftfahrzeug mit einer Bedienoberfläche beschrieben, unter der diskrete Verformungselemente angeordnet sind. Die Verformungselemente können mit Hilfe einer elektrisch ansteuerbaren Formgedächtnislegierung aus der Ebene der Bedienoberfläche heraus bewegt werden. Dadurch werden auf der Bedienoberfläche Erhöhungen gebildet, die einem Bediener als haptische Orientierung auf der Bedienoberfläche dienen.

Schließlich ist aus der DE 10 2015 015 417 A1 ebenso eine Bedienvorrichtung für ein Kraftfahrzeug bekannt. Bei dem Bedienelement ist unter einer Bedienoberfläche eine Ausnehmung vorhanden, wobei zwischen der Ausnehmung und der Bedienoberfläche ein Piezoelement angeordnet ist. Durch elektrische Ansteuerung kann das Piezoelement derart verformt werden, dass dies zu einer Einbuchtung oder zu einer Ausbuchtung der Bedienoberfläche führt. Hierdurch kann während einer Bedienhandlung ein für eine Bedienperson wahrnehmbares, haptisches Signal erzeugt werden.

Ausgehend von dem vorliegenden Stand der Technik liegt der vorliegenden Erfindung die Aufgabe zu Grunde, ein Verfahren zur Ansteuerung einer Bedienvorrichtung für ein Kraftfahrzeug bereitzustellen, welches zuverlässig und auf einfache Weise die Erzeugung einer haptischen Rückmeldung bei Bedienung der Bedienvorrichtung ermöglicht.

Eine weitere Aufgabe der Erfindung ist die Bereitstellung einer geeigneten Bedienvorrichtung zur Durchführung des Verfahrens, welche insbesondere einfach und kostengünstig aufgebaut ist.

Vorliegende Aufgaben werden mit einem Verfahren gemäß den Merkmalen von Patentanspruch 1 und einer Bedienvorrichtung gemäß den Merkmalen von Patentanspruch 5 gelöst.

Vorteilhafte Weiterbildungen beziehungsweise Ausbildungen der Erfindung sind den jeweils abhängigen Ansprüchen entnehmbar.

Hinsichtlich des Verfahrens geht die Erfindung aus von einem Verfahren zur Ansteuerung einer Bedienvorrichtung für ein Kraftfahrzeug. Dabei weist die Bedienvorrichtung ein Bedienelement auf, wobei ein unter dem Bedienelement angeordnetes, federelastisches Element durch ein Piezoelement mittel- oder unmittelbar bewegt und/oder verformt wird. Dies erfolgt, um einem Bediener wenigstens eine haptische Rückmeldung während einer Betätigung des Bedienelementes zu geben.

Die Erfindung schlägt nun vor, dass das federelastische Element bei Ansteuerung des Piezoelementes in Richtung des Bedienelementes bewegt und mit diesem in einen Wirkkontakt gebracht wird. Dies führt dazu, dass das federelastische Element bei Betätigung des Bedienelementes von einer stabilen Ausgangsposition in eine instabile Verformungsposition überführt wird. Bei einem Loslassen des Bedienelementes gelangt das federelastische Element von der Verformungsposition selbsttätig wieder zurück zur Ausgangsposition. Bei einem Wechsel von der Ausgangsposition zur Verformungsposition und umgekehrt wird durch das federelastische Element jeweils eine haptische Rückmeldung erzeugt.

Das federelastische Element wird bei Ansteuerung des Piezoelementes vorzugsweise translatorisch in Richtung des Bedienelements bewegt. Die haptische Rückmeldung entsteht dabei während des Übergangs von der Ausgangsposition zur Verformungsposition und umgekehrt. Es wird also keine oszillierende oder schwingende haptische Rückmeldung erzeugt, sondern eine einfache, singuläre haptische Rückmeldung. Dies ermöglicht die Erzeugung eines bekannten Betätigungsgefühls, wie man es beispielsweise von einer Computertastatur oder dergleichen gewohnt ist.

Gemäß einer Weiterbildung der Erfindung wird vorgeschlagen, dass erfasst wird, ob sich ein Bedienwerkzeug eines Bedieners einer Bedienoberfläche des Bedienelementes nähert oder diese berührt. Das Piezoelement wird nur dann angesteuert, wenn sich ein Bedienwerkzeug eines Bedieners der Bedienoberfläche nähert oder diese berührt. Durch diese Merkmale wird sichergestellt, dass das Piezoelement nur dann bestromt wird, wenn eine haptische Rückmeldung eventuell auch erforderlich ist. Dies führt zu einer Reduktion des Stromverbrauchs. Abgesehen davon kann die Bedienvorrichtung überhaupt nur dann angesteuert werden, wenn die Bordelektronik eingeschaltet ist.

Nach einer anderen höchst vorteilhaften Ausbildung des Erfindungsgedankens wird erfasst, welcher Position auf der Bedienoberfläche des Bedienelementes sich ein Bedienwerkzeug eines Bedieners nähert oder welche Position dieses berührt. Das Piezoelement wird dabei nur dann angesteuert, wenn sich ein Bedienwerkzeug eines Bedieners bestimmten Positionen auf der Bedienoberfläche nähert oder diese berührt.

Durch diese Ausgestaltung des Verfahrens wird es ermöglicht, eine haptische Rückmeldung nur dann zu erzeugen, wenn ein bestimmtes Bediensymbol auf der Bedienoberfläche auch wirklich bedient werden soll. Sind beispielsweise auf einer größeren Bedienoberfläche mehrere Symbole angeordnet und berührt ein Bedienwerkzeug eines Bedieners Positionen zwischen den Bediensymbolen, so wird das Piezoelement nicht angesteuert und der Bediener hat das Gefühl, dass er lediglich eine "tote", steife Bedienoberfläche berührt.

Um einem Bediener bei der Bedienung der Bedienvorrichtung auch eine geeignete akustische Rückmeldung geben zu können wird vorgeschlagen, bei einem Wechsel des federelastischen Elementes von der Ausgangsposition zur Verformungsposition und umgekehrt durch das federelastische Element jeweils zusätzlich ein akustisches, singuläres Geräusch zu erzeugen. Es wird also kein kontinuierliches Signal, wie etwa ein Brummen oder ein Summen, sondern ein kurzzeitiges Geräusch wie etwa ein Knacken oder ein Klicken erzeugt. Dies passt sehr gut mit der beschriebenen haptischen Rückmeldung zusammen und stellt für einen Bediener ein vertrautes Geräusch dar.

Wie bereits erwähnt, betrifft die Erfindung auch eine Bedienvorrichtung zur Durchführung des Verfahrens. Die Bedienvorrichtung ist mit einem Bedienelement ausgestattet, welches eine Bedienoberfläche aufweist. Ferner ist das Bedienelement von einem Gehäuse umrahmt. Unter dem Bedienelement ist ein federelastisches Element vorhanden, welches durch ein Piezoelement mittel- oder unmittelbar bewegbar und/oder verformbar ist.

Die Bedienvorrichtung ist dadurch gekennzeichnet, dass das Piezoelement derart ansteuerbar ist, dass das federelastische Element durch das Piezoelement in Richtung des Bedienelementes bewegt und mit diesem in einen Wirkkontakt gebracht wird. Die Bewegung des Piezoelementes in Richtung des Bedienelementes erfolgt vorzugsweise translatorisch. Durch den hergestellten Wirkkontakt kann das federelastische Element bei Betätigung, also durch Drücken des Bedienelementes von einer stabilen Ausgangsposition in eine instabile Verformungsposition überführt werden. Von der instabilen Verformungsposition kann das Bedienelement bei einem Loslassen selbsttätig wieder zurück zur Ausgangsposition gelangen. Bei einem Wechsel von der Ausgangsposition zur Verformungsposition und umgekehrt ist durch das federelastische Element jeweils eine haptische Rückmeldung erzeugbar.

Das federelastische Element ist vorzugsweise aus Metall. Es sind aber auch andere Materialien wie beispielsweise Kunststoff denkbar.

Eine solche Bedienvorrichtung dient zur preiswerten und zuverlässigen Durchführung des erfindungsgemäßen Verfahrens. Besonders kostengünstig kann die Bedienvorrichtung allerdings dann realisiert werden, wenn das federelastische Element eine handelsübliche Knackscheibe ist. Handelsübliche Knackscheiben weisen in der Regel einen kreisrunden Umriss auf und die bekannten, für die vorliegende Erfindung sehr geeigneten "Knackfrosch-Eigenschaften". Das heißt, bei Druck auf die Knackscheibe und Überwindung eines bestimmten, eine haptische Rückmeldung bildenden Widerstandes kollabiert diese unter Abgabe eines Knackgeräusches. Nach Nachlassen des Druckes geht die Knackscheibe ebenso unter Abgabe eines Knackgeräusches und Erzeugung einer haptischen Rückmeldung wieder in ihre Ausgangsposition zurück.

Um den Druckpunkt für das federelastische Element möglichst genau wiederholbar zu machen, ist es sehr zweckmäßig, wenn das federelastische Element durch wenigstens eine Wandung des Gehäuses in Richtung seiner Mittelachse, also in Richtung seiner translatorischen Bewegung, geführt ist.

Um ein Kippen des Bedienelementes bei Druck auf ein Bediensymbol außerhalb der Mitte des Bedienelementes oder gar an dessen Rand zu vermeiden, wird gemäß einer anderen Ausbildung der Erfindung vorgeschlagen, dass das Bedienelement durch wenigstens eine Wandung des Gehäuses in seiner Betätigungsrichtung geführt ist. Weist beispielsweise das Bedienelement in seinem Umriss eine kreisrunde Form auf, so kann die Wandung des Gehäuses vorzugsweise den gesamten Umriss des Bedienelementes umschließen. Bei einer rechteckigen Ausbildung des Bedienelement-Umrisses kann die Führung zumindest an zwei parallelen Außenseiten des Bedienelementes erfolgen. Abweichend davon sind auch andere Lösungen denkbar, um eine Kippfreiheit zu erzielen.

Es ist gemäß einer anderen Weiterbildung höchst vorteilhaft, wenn die Bedienoberfläche des Bedienelementes als Näherungs- und/oder berührungssensitive Oberfläche ausgebildet ist. Dabei ist eine Auswerte- und Steuereinrichtung vorhanden, durch welche erfassbar ist, welcher Position sich ein Bedienwerkzeug eines Bedieners auf der Bedienoberfläche nähert oder welche Position dieses berührt.

Auf diese Weise kann sichergestellt werden, dass eine Schaltbarkeit des Bedienelementes beziehungsweise die Erzeugung einer haptischen und/oder akustischen Rückmeldung nur dann möglich wird, wenn ein bestimmtes Bediensymbol auf der Bedienoberfläche des Bedienelementes berührt wird oder eine Annäherung an dieses erfolgt.

In diesem Zusammenhang ist es einer leichten Bedienbarkeit sehr zuträglich, wenn auf der Bedienoberfläche mehrere Bediensymbole angeordnet sind und die Bedienoberfläche als durchgängige, vorzugsweise ebene Oberfläche ausgebildet ist. Unter dem Begriff "Bediensymbol" sind auch Zahlen, Buchstaben, Piktogramme und dergleichen zu verstehen.

Schließlich soll mit der Erfindung auch ein Kraftfahrzeug unter Schutz gestellt werden, welches wenigstens eine erfindungsgemäße Bedienvorrichtung aufweist.

Ein bevorzugtes Ausführungsbeispiel der Erfindung ist in den Figuren dargestellt und wird anhand der Figuren in der nachfolgenden Beschreibung näher erläutert. Dadurch werden auch noch weitere Vorteile der Erfindung deutlich. Gleiche Bezugszeichen, auch in unterschiedlichen Figuren, beziehen sich auf gleiche, vergleichbare oder funktional gleiche Bauteile. Dabei werden entsprechende oder vergleichbare Eigenschaften und Vorteile erreicht, auch wenn eine wiederholte Beschreibung oder Bezugnahme darauf nicht erfolgt. Die Figuren sind nicht immer maßstabsgetreu. In manchen Figuren können Proportionen übertrieben dargestellt sein, um Merkmale eines Ausführungsbeispiels deutlicher hervorheben zu können.

Es zeigen, jeweils schematisch
- Fig. 1: die Darstellung einer erfindungsgemäßen Bedienvorrichtung im vorderen Innenraum eines Kraftfahrzeugs,
- Fig. 2a: eine Ansicht gemäß mit Schnittverlauf II aus Fig. 1, in die Horizontale gedreht, in einem ersten Betriebszustand,
- Fig. 2b: eine Darstellung vergleichbar mit Fig. 2a, in einem zweiten Betriebszustand,
- Fig. 3: eine Ansicht auf das Piezoelement mitsamt dem federelastischen Element gemäß Ansicht III aus Fig. 2b, in Alleinstellung,
- Fig. 4: eine seitliche Darstellung des federelastischen Elementes in Alleinstellung, in zwei unterschiedlichen Betriebszuständen und
- Fig. 5: eine Draufsicht auf die Bedienoberfläche des Bedienelementes gemäß Ansicht III aus Fig. 2b.

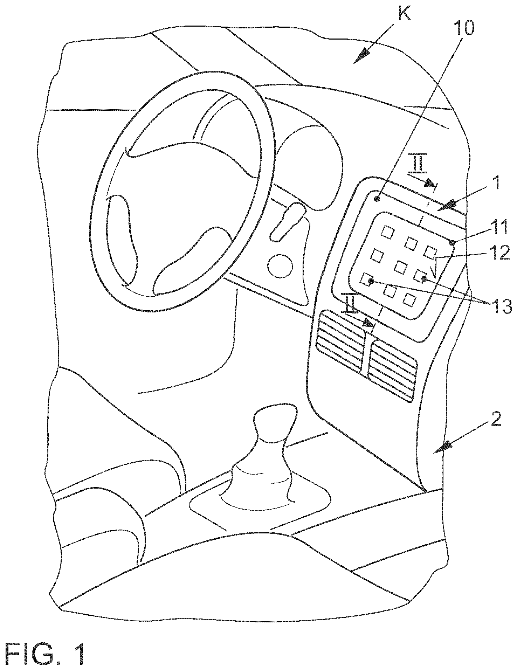

Es wird zunächst auf die Fig. 1 Bezug genommen. In dieser Figur ist der Innenraum eines Kraftfahrzeugs K im Bereich seiner Mittelkonsole 2 dargestellt.

Es ist ersichtlich, dass im Bereich der Mittelkonsole 2 eine Bedienvorrichtung 1 angeordnet ist. Die Bedienvorrichtung 1 weist ein betätigbares, insbesondere drückbares Bedienelement 11 auf, welches umrissseitig von einem Gehäuse 10 umgeben bzw. umrahmt ist. Auf einer Bedienoberfläche 12 des Bedienelementes 11 sind mehrere Bediensymbole 13 angeordnet.

Beim Betätigen des Bedienelementes 11 durch Berührung einer der Bediensymbole 13 und Drücken des Bedienelementes 11 ist es erwünscht, dass nicht nur die entsprechende, dem Bediensymbol 13 hinterlegte Funktion ausgeführt, sondern auch eine haptische und/oder sogar eine akustische Rückmeldung über die erfolgte Bedienung an den Bediener zurückgegeben wird.

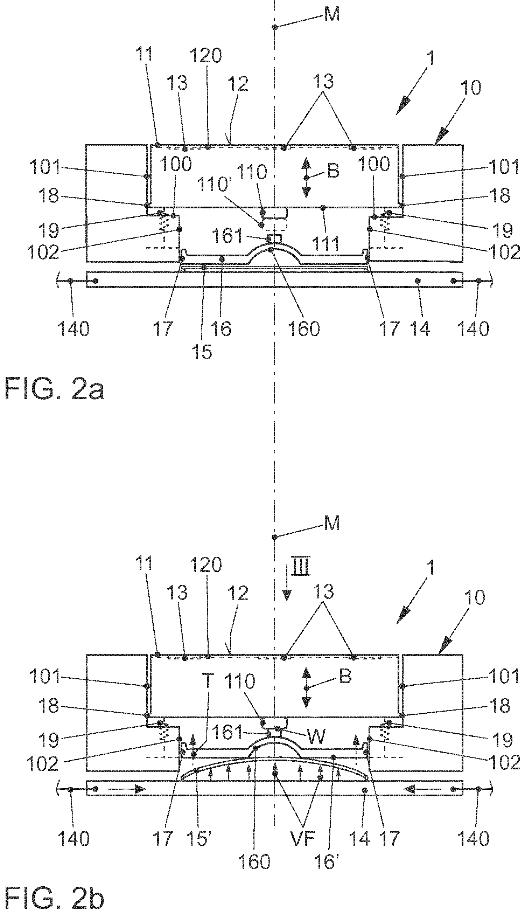

Hierzu ist die Bedienvorrichtung 1 speziell ausgebildet, wie es nun anhand der Figuren 2 näher erläutert wird. So ist in Fig. 2a, welche einen Querschnitt durch die Bedienvorrichtung 1 darstellt, ein erster Betriebszustand der Bedienvorrichtung 1 ersichtlich.

Es ist erkennbar, dass das Bedienelement 11 seitlich von Wandungen 101 des Gehäuses 10 geführt, insbesondere parallel geführt ist (vergleiche Führungen 18). Auf diese Weise wird sichergestellt, dass auch bei einer außermittigen Betätigung des Bedienelementes 11 dieses während einer translatorischen Bewegung in Betätigungsrichtung B nicht kippelt.

Die Betätigung des Bedienelementes 11 erfolgt durch Drücken mittels eines Bedienwerkzeugs (beispielsweise Finger, nicht dargestellt) auf die Bedienoberfläche 12.

Hierdurch verschiebt sich das Bedienelement 11, welches vorzugsweise als stabiler, im Wesentlichen unnachgiebiger Körper ausgebildet ist, in Richtung eines federelastischen Elementes 16.

Das federelastische Element 16 befindet sich unmittelbar unterhalb des Bedienelementes 11. Es ist zumindest an zwei Stellen durch eine Wandung 102 des Gehäuses 10 geführt, insbesondere parallel geführt (vergleiche Führungen 17).

Unterhalb des federelastischen Elementes 16 ist ein Verformungselement 15 vorhanden, auf das das federelastische Element 16 aufliegt. In der Darstellung ist nur der besseren Lesbarkeit halber ein kleiner Abstand zwischen diesen Bauteilen gelassen. Das Verformungselement 15 ist an seinem Randbereich beziehungsweise entlang seines Umrisses mit einem darunter befindlichen Piezoelement 14 verbunden.

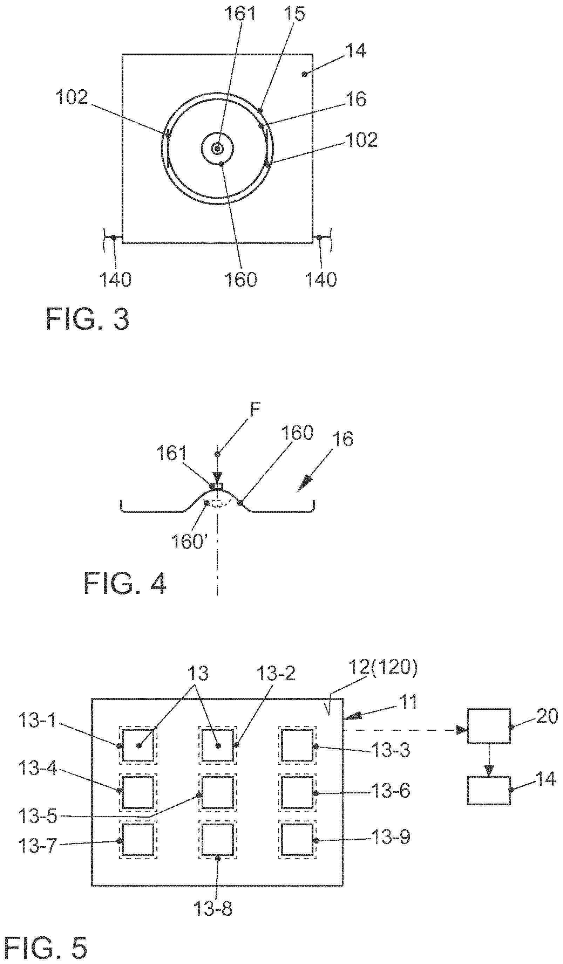

Das Piezoelement 14 wiederum ist über elektrische Anschlüsse 140 mit einer hier nicht dargestellten Auswerte- und Steuereinrichtung 20 signaltechnisch verbunden (vergleiche Fig. 5).

Federelemente 19, vorzugsweise in Form von Schraubendruckfedern, halten das Bedienelement 11 federelastisch in der dargestellten Position.

Wird im dargestellten Betriebszustand das Bedienelement 11 betätigt, also niedergedrückt, so wird das Bedienelement 11 in seiner Betätigungsrichtung B so weit nach unten gedrückt, bis eine Unterseite 111 des Bedienelementes 11 gegen einen Absatz 100 des Gehäuses 10 anstößt.

Allerdings wird im vorliegenden Betriebszustand der Bedienvorrichtung bei einem Niederdrücken des Bedienelementes 11 weder eine Funktion ausgelöst noch erhält ein Bediener eine haptische oder akustische Rückmeldung über eine erfolgte Betätigung des Bedienelementes 11.

Vielmehr hat ein Bediener das Gefühl, gegen eine starre Platte ohne jegliche Rückmeldung zu drücken. Denn beim Anschlag der Unterseite 111 gegen den Absatz 100 wird zwar auch ein unterseitiges Kontaktelement 110 in Richtung des federelastischen Elementes 16 verschoben (vergleiche Ziffer 110'), dieses gelangt jedoch nicht in einen Wirkkontakt mit einem vorhandenen, knopfartigen Kontaktelement 161 des federelastischen Elementes 16.

Eine Auslösung einer bestimmten Funktion und die Bereitstellung einer entsprechenden haptischen und/oder akustischen Rückmeldung ist erst dann möglich, wenn die Bedienvorrichtung 1 "scharfgeschaltet" ist, wie es in Fig. 2b dargestellt wird. Eine Scharfschaltung der Bedienvorrichtung 1 erfolgt in Abhängigkeit einer Berührung der Bedienoberfläche 12 an bestimmten Positionen, was mit Hilfe einer näherungs- und berührungsempfindlichen Schicht 120 der Bedienoberfläche 12 erfasst wird. Dies wird später noch näher erläutert.

Liegen die Voraussetzung für eine Scharfschaltung der Bedienvorrichtung 1 vor, so wird das Piezoelement 14 über die elektrischen Anschlüsse 140 entsprechend angesteuert. Dies führt dazu, dass sich das Piezoelement 14 in Richtung seiner Längserstreckung nach innen zusammenzieht (vergleiche Pfeile). Die Folge davon ist eine Verformung des Verformungselementes 15 dahingehend, dass es sich konkav nach oben, in Richtung des federelastischen Elementes 16 anhebt (vergleiche Verformung VF und Position 15').

Mit der Verformung VF des Verformungselementes 15 wird gleichzeitig auch das federelastische Element 16 in Form einer translatorischen Bewegung T nach oben in Richtung des Bedienelementes 11 bewegt. Die translatorische Bewegung T erfolgt so weit, bis das Kontaktelement 161 des federelastischen Elements 16 und das Kontaktelement 110 des Bedienelementes 11 miteinander in einen Wirkkontakt W gelangen (vergleiche Position 16'). Erst dann ist die Bedienvorrichtung 1 scharfgeschaltet. Die Scharfschaltung kann innerhalb kürzester Zeiträume, vorzugsweise im Millisekundenbereich erfolgen.

Sowohl die Betätigungsrichtung B des Bedienelementes 11 als auch die translatorische Bewegung T des federelastischen Elementes 16 erfolgen in Richtung einer Mittelpunktachse M, in deren Richtung auch die genannten Führungen 17 und 18 wirken.

Wie aus den Figuren 2 und der Fig. 3 ersichtlich wird, sind das Verformungselement 15 und das federelastische Element 16 vorzugsweise kreisrund ausgebildet. Das Piezoelement 14, auf dem das Verformungselement 15 befestigt ist, ist hingegen rechteckig, vorzugsweise quadratisch ausgebildet. Das Verformungselement 15 ist vorzugsweise eine dünne Scheibe und aus Metall ausgebildet.

Das federelastische Element 16 weist eine tellerartige Form auf, mit einem erhöhten, umlaufenden Randbereich und einer mittleren Ausbuchtung 160. Auf der Ausbuchtung 160 ist im Bereich der Mittelpunktsachse M das Kontaktelement 161 angeordnet.

Wird nun im scharfgestellten Zustand gemäß Fig. 2b das Bedienelement 11 an richtiger Stelle betätigt, also entgegen der Federkraft der Federn 19 niedergedrückt, so wird das federelastische Element 16 von seiner in Fig. 2b dargestellten, stabilen Ausgangsposition in eine instabile Verformungsposition überführt und löst dabei zumindest eine haptische Rückmeldung an einen Bediener aus. Gleichzeitig werden nicht näher dargestellte Signalkontakte geschlossen, die zu einer Funktionsauslösung einer gewünschten Funktion führen.

Beim Loslassen des Bedienelementes 11 gelangt das Bedienelement 11 durch die Federkraft der Federelemente 19 wieder zurück in seine Ausgangsposition. Gleichzeitig wird das federelastische Element 16 von seiner Verformungsposition selbsttätig wieder zurück zur Ausgangsposition überführt. Auch hierbei erhält der Bediener wieder zumindest eine haptische Rückmeldung, welche vom federelastischen Element 16 erzeugt wird.

Die beiden genannten Zustände des federelastischen Elementes 16 sollen noch einmal anhand von Fig. 4 kurz erläutert werden. Darin ist das federelastische Element 16, welches ebenfalls vorzugsweise aus Metall ist, in Alleinstellung dargestellt. Das federelastische Element 16 ist bevorzugt als handelsübliche Knackscheibe ausgeführt. Mit der durchgezogenen Linie ist die stabile Ausgangsposition des federelastischen Elementes 16 dargestellt. Wird in dieser Ausgangsposition eine Betätigungskraft F auf das Kontaktelement 161 ausgeübt, so gelangt das federelastische Element 16 im Bereich seiner Ausbuchtung 160 in die genannte, instabile Verformungsposition. Die instabile Verformungsposition ist durch eine Einstülpung 160' gekennzeichnet (gestrichelt angedeutet). Bei Nachlassen oder Ausbleiben der Betätigungskraft F stülpt sich die Einstülpung 160' wieder zur Ausbuchtung 160 aus. Bei Übergang von einer der genannten Positionen zur anderen erfolgt jedes Mal eine haptische Rückmeldung und je nach Dimensionierung auch die Ausgabe eines hörbaren, singulären Geräuschs. Das Geräusch ist vorzugsweise ein knackendes oder klickendes Geräusch.

Schließlich wird anhand von Fig. 5 erläutert, unter welchen Bedingungen die Bedienvorrichtung 1 scharfgeschaltet wird.

So ist die Bedienoberfläche 12, wie bereits erwähnt, mit einer näherungs- und berührungsempfindlichen Schicht 120 versehen. Durch diese Schicht 120 kann erfasst werden, auf welcher Position genau sich ein Bedienwerkzeug eines Bedieners der Bedienoberfläche 12 nähert oder auf welcher Position die Bedienoberfläche 12 berührt wird. So sind den Bediensymbolen 13 bestimmte Positionen 13-1 bis 13-9 beziehungsweise bestimmte Positionsbereiche auf der Bedienoberfläche 12 zugeordnet.

Erfolgt eine Annäherung an eine dieser Positionen oder eine Berührung eine dieser Positionen, so wird dies in geeigneter Weise erfasst und von einer Auswerte- und Steuereinrichtung 20 ausgewertet. Die Auswerte- und Steuereinrichtung 20 steuert daraufhin das Piezoelement 14 derart an, dass in beschriebener Weise eine Scharfschaltung der Bedienvorrichtung 1 erfolgt.

Wird eine Annäherung oder Berührung der Bedienoberfläche 12 lediglich an Positionen außerhalb der besagten Positionen 13-1 bis 13-9 erfasst, so erfolgt keine Scharfschaltung der Bedienvorrichtung 1. Diese bleibt bei einer Berührung "hart" und vermittelt kein Schaltgefühl. Es wird auch kein Schaltsignal erzeugt oder weitergeleitet.

In Abweichung zum dargestellten Ausführungsbeispiel ist es denkbar, dass mehr oder weniger der Bediensymbole 13 auf der Bedienoberfläche 12 angeordnet sein können. In jedem Falle erfolgt aufgrund der Führungen 18 (vgl. Figuren 2) eine kippfreie Verschiebung des Bedienelementes 11, unabhängig davon, wo dieses berührt wird.

Des Weiteren ist zu erwähnen, dass die Bedienoberfläche 12 vorzugsweise als durchgängige Bedienoberfläche ausgebildet ist. Zwischen den einzelnen Bediensymbolen 13 sind also keine Zwischenräume, Schlitze oder dergleichen vorhanden. Hierdurch können das Bediengefühl und auch die Unempfindlichkeit der Bedienvorrichtung 1 gegen Verschmutzung verbessert werden. Dabei kann die Bedienoberfläche eben oder auch gekrümmt, beispielsweise konvex oder konkav ausgebildet sein.

### Bezugszeichenliste

- 1: Bedienvorrichtung
- 2: Mittelkonsole
- 10: Gehäuse
- 11: Bedienelement
- 12: Bedienoberfläche
- 13: Bediensymbole
- 13-1 bis 13-9: Positionen auf der Bedienoberfläche
- 14: Piezoelement
- 15, 15': Verformungselement
- 16, 16': federelastisches Element
- 17: Führung
- 18: Führung
- 19: Federelemente
- 20: Auswerte- und Steuereinrichtung
- 100: Absatz
- 101: Wandung
- 102: Wandung
- 110, 110': Kontaktelement
- 111: Unterseite
- 120: näherungs- und berührungsempfindliche Schicht
- 140: elektrische Anschlüsse
- 160: Ausbuchtung
- 160': Einstülpung
- 161: Kontaktelement

- B: Betätigungsrichtung
- F: Betätigungskraft
- K: Kraftfahrzeug
- M: Mittelpunktachse
- T: translatorische Bewegung
- VF: Verformung
- W: Wirkkontakt

## Patentansprüche

1. Verfahren zur Ansteuerung einer Bedienvorrichtung (1) für ein Kraftfahrzeug (K), mit einem Bedienelement (11), wobei ein unter dem Bedienelement (11) angeordnetes, federelastisches Element (16) durch ein Piezoelement (14) mittel- oder unmittelbar bewegt und/oder verformt wird, um einem Bediener wenigstens eine haptische Rückmeldung während einer Betätigung des Bedienelementes (11) zu geben, **dadurch gekennzeichnet, dass** das federelastisches Element (16) bei Ansteuerung des Piezoelementes (14) in Richtung des Bedienelementes (11) bewegt und mit diesem in einen Wirkkontakt (W) gebracht wird, derart, dass das federelastische Element (16) bei Betätigung des Bedienelementes (11) von einer stabilen Ausgangsposition in eine instabile Verformungsposition überführt wird und bei einem Loslassen des Bedienelementes (11) das federelastisches Element (16) von der Verformungsposition selbsttätig wieder zurück zur Ausgangsposition gelangt, wobei bei einem Wechsel von der Ausgangsposition zur Verformungsposition und umgekehrt durch das federelastisches Element (16) jeweils eine haptische Rückmeldung erzeugt wird.

2. Verfahren nach Anspruch 1, **dadurch gekennzeichnet, dass** erfasst wird, ob sich ein Bedienwerkzeug eines Bedieners einer Bedienoberfläche (12) des Bedienelementes (11) nähert oder diese berührt, wobei das Piezoelement (14) nur dann angesteuert wird, wenn sich ein Bedienwerkzeug eines Bedieners der Bedienoberfläche (12) nähert oder diese berührt.

3. Verfahren nach Anspruch 1, **dadurch gekennzeichnet, dass** erfasst wird, welcher Position auf einer Bedienoberfläche (12) des Bedienelementes (11) sich ein Bedienwerkzeug eines Bedieners nähert oder welche Position dieses berührt, wobei das Piezoelement (14) nur dann angesteuert wird, wenn sich ein Bedienwerkzeug eines Bedieners bestimmten Positionen (13-1 bis 13-9) auf der Bedienoberfläche (12) nähert oder diese berührt.

4. Verfahren nach einem der vorhergehenden Ansprüche, **dadurch gekennzeichnet, dass** bei einem Wechsel des federelastischen Elementes (16) von der Ausgangsposition zur Verformungsposition und umgekehrt durch das federelastische Element (16) jeweils zusätzlich ein akustisches, singuläres Geräusch erzeugt wird.

5. Bedienvorrichtung (1) zur Durchführung des Verfahrens nach einem der vorhergehenden Ansprüche, mit einem Bedienelement (11), *welches von einem Gehäuse (10) umgeben ist und* welches eine Bedienoberfläche (12) aufweist, wobei unter dem Bedienelement (11) ein federelastisches Element (16) durch ein Piezoelement (14) bewegbar und/oder verformbar ist, **dadurch gekennzeichnet, dass** das Piezoelement (14) derart ansteuerbar ist, dass das federelastische Element (16) durch das Piezoelement (14) in Richtung des Bedienelementes (11) bewegt und mit diesem in einen Wirkkontakt (W) gebracht wird und das federelastisches Element (16) bei Betätigung des Bedienelementes (11) von einer stabilen Ausgangsposition in eine instabile Verformungsposition überführbar ist, von der es bei einem Loslassen des Bedienelementes (11) selbsttätig wieder zurück zur Ausgangsposition gelangen kann, wobei bei einem Wechsel von der Ausgangsposition zur Verformungsposition und umgekehrt durch das federelastisches Element (16) jeweils eine haptische Rückmeldung erzeugbar ist.

6. Bedienvorrichtung (1) nach Anspruch 5, **dadurch gekennzeichnet, dass** das federelastische Element (16) eine handelsübliche Knackscheibe ist.

7. Bedienvorrichtung (1) nach einem der vorhergehenden Anspruch 5 oder 6, **dadurch gekennzeichnet, dass** das federelastische Element (16) durch wenigstens eine Wandung (102) des Gehäuses (10) in Richtung seiner Bewegung (T) geführt ist.

8. Bedienvorrichtung (1) nach einem der vorhergehenden Anspruch 5 bis 7, **dadurch gekennzeichnet, dass** das Bedienelement (11) durch wenigstens eine Wandung (101) des Gehäuses (10) in seiner Betätigungsrichtung (B) geführt ist.

9. Bedienvorrichtung (1) nach einem der vorhergehenden Anspruch 5 bis 8, **dadurch gekennzeichnet, dass** die Bedienoberfläche (12) des Bedienelementes (11) als näherungs- und/oder berührungssensitive Oberfläche ausgebildet ist und eine Auswerte- und Steuereinrichtung (20) vorhanden ist, durch welche erfassbar ist, welcher Position sich ein Bedienwerkzeug eines Bedieners auf der Bedienoberfläche (12) nähert oder welche Position dieses berührt.

10. Bedienvorrichtung (1) nach Anspruch 9, **dadurch gekennzeichnet, dass** auf der Bedienoberfläche (12) mehrere Bediensymbole (13) angeordnet sind und die Bedienoberfläche (12) als durchgängige Oberfläche ausgebildet ist.

11. Kraftfahrzeug (K), **gekennzeichnet durch** wenigstens eine Bedienvorrichtung (1) nach einem der vorhergehenden Ansprüche 5 bis 10.

## Claims

1. Method for actuating an operator control apparatus (1) for a motor vehicle (K), comprising an operator control element (11), wherein a spring-elastic element (16), which is arranged beneath the operator control element (11), is indirectly or directly moved and/or deformed by a piezo element (14) in order to provide at least one item of haptic feedback to an operator during operation of the operator control element (11), **characterized in that** the spring-elastic element (16), when the piezo element (14) is actuated, is moved in the direction of the operator control element (11) and is brought into operative contact (W) with the said operator control element in such a way that the spring-elastic element (16) is moved from a stable starting position to an unstable deformation position when the operator control element (11) is operated and the spring-elastic element (16) automatically returns from the deformation position back to the starting position when the operator control element (11) is released, wherein an item of haptic feedback is generated by the spring-elastic element (16) each time a changeover is made from the starting position to the deformation position, and vice versa.

2. Method according to Claim 1, **characterized in that** detection is performed to determine whether an operator control tool of an operator is approaching an operator control surface (12) of the operator control element (11) or is touching said operator control surface, wherein the piezo element (14) is actuated only when an operator control tool of an operator is approaching the operator control surface (12) or is touching the said operator control surface.

3. Method according to Claim 1, **characterized in that** detection is performed to determine the position on an operator control surface (12) of the operator control element (11) that an operator control tool of an operator is approaching or the position that the said operator control tool is touching, wherein the piezo element (14) is actuated only when an operator control tool of an operator is approaching specific positions (13-1 to 13-9) on the operator control surface (12) or is touching the said specific positions.

4. Method according to one of the preceding claims, **characterized in that** an acoustic, singular noise is additionally generated by the spring-elastic element (16) each time the spring-elastic element (16) changes over from the starting position to the deformation position, and vice versa.

5. Operator control apparatus (1) for carrying out the method according to one of the preceding claims, comprising an operator control element (11) which is surrounded by a housing (10) and which has an operator control surface (12), wherein a spring-elastic element (16) can be moved and/or can be deformed by a piezo element (14) beneath the operator control element (11), **characterized in that** the piezo element (14) can be actuated in such a way that the spring-elastic element (16) is moved in the direction of the operator control element (11) and brought into operative contact (W) with the said operator control element by the piezo element (14), and the spring-elastic element (16) can be moved from a stable starting position to an unstable deformation position when the operator control element (11) is operated, it being possible for the said spring-elastic element to be automatically returned back to the starting position when the operator control element (11) is released, wherein an item of haptic feedback can be generated by the spring-elastic element (16) each time a changeover is made from the starting position to the deformation position, and vice versa.

6. Operator control apparatus (1) according to Claim 5, **characterized in that** the spring-elastic element (16) is a commercially available crack disc.

7. Operator control apparatus (1) according to either of the preceding Claims 5 and 6, **characterized in that** the spring-elastic element (16) is passed through at least one wall (102) of the housing (10) in the direction of movement (T) of the said spring-elastic element.

8. Operator control apparatus (1) according to one of the preceding Claims 5 to 7, **characterized in that** the operator control element (11) is passed through at least one wall (101) of the housing (10) in the operating direction (B) of the said operator control element.

9. Operator control apparatus (1) according to one of the preceding Claims 5 to 8, **characterized in that** the operator control surface (12) of the operator control element (11) is designed as a proximity- and/or touch-sensitive surface and there is an evaluation and control device (20) by way of which it is possible to detect the position that an operator control tool of an operator is approaching on the operator control surface (12) or the position that the said operator control tool is touching.

10. Operator control apparatus (1) according to Claim 9, **characterized in that** a plurality of operator control symbols (13) are arranged on the operator control surface (12) and the operator control surface (12) is designed as a continuous surface.

11. Motor vehicle (K), **characterized by** at least one operator control apparatus (1) according to one of the preceding Claims 5 to 10.

## Revendications

1. Procédé de commande d'un dispositif d'opération (1) pour un véhicule automobile (K), comprenant un élément d'opération (11), un élément (16) à élasticité de ressort disposé sous l'élément d'opération (11) étant déplacé et/ou déformé directement ou indirectement par un élément piézoélectrique (14) afin de communiquer à un opérateur une rétroaction au moins haptique pendant un actionnement de l'élément d'opération (11), **caractérisé en ce que** l'élément (16) à élasticité de ressort, lors de l'excitation de l'élément piézoélectrique (14), est déplacé en direction de l'élément d'opération (11) et est amené en un contact fonctionnel (W) avec celui-ci de telle sorte que l'élément (16) à élasticité de ressort, lors de l'actionnement de l'élément d'opération (11), est transféré d'une position initiale stable dans une position de déformation instable et, lors d'un relâchement de l'élément d'opération (11), l'élément (16) à élasticité de ressort est automatiquement de nouveau ramené de la position de déformation à la position initiale, une rétroaction haptique étant respectivement générée par l'élément (16) à élasticité de ressort lors d'un changement de la position initiale à la position de déformation et inversement.

2. Procédé selon la revendication 1, **caractérisé en ce qu'**il est détecté si un outil d'opération d'un opérateur s'approche d'une interface d'opération (12) de l'élément d'opération (11) ou touche celle-ci, l'élément piézoélectrique (14) n'étant excité que si un outil d'opération d'un opérateur d'approche de l'interface d'opération (12) ou touche celle-ci.

3. Procédé selon la revendication 1, **caractérisé en ce que** la position sur une interface d'opération (12) de l'élément d'opération (11) de laquelle s'approche un outil d'opération d'un opérateur ou la position que celui-ci touche est détectée, l'élément piézoélectrique (14) n'étant excité que si un outil d'opération d'un opérateur s'approche de positions (13-1 à 13-9) prédéterminées sur l'interface d'opération (12) ou les touche.

4. Procédé selon l'une des revendications précédentes, **caractérisé en ce que** lors d'un changement de l'élément (16) à élasticité de ressort de la position initiale à la position de déformation et inversement, un bruit acoustique singulier est respectivement généré en plus par l'élément (16) à élasticité de ressort.

5. Dispositif d'opération (1) destiné à mettre en œuvre le procédé selon l'une des revendications précédentes, comprenant un élément d'opération (11), *qui est entouré par un boîtier (10) et* qui possède une interface d'opération (12), un élément (16) à élasticité de ressort sous l'élément d'opération (11) pouvant être déplacé et/ou déformé par un élément piézoélectrique (14), **caractérisé en ce que** l'élément piézoélectrique (14) peut être excité de telle sorte que l'élément (16) à élasticité de ressort est déplacé par l'élément piézoélectrique (14) en direction de l'élément d'opération (11) et est amené en un contact fonctionnel (W) avec celui-ci et l'élément (16) à élasticité de ressort, lors de l'actionnement de l'élément d'opération (11), peut être transféré d'une position initiale stable dans une position de déformation instable depuis laquelle, lors d'un relâchement de l'élément d'opération (11), il peut automatiquement être ramené vers la position initiale, une rétroaction haptique pouvant respectivement être générée par l'élément (16) à élasticité de ressort lors d'un changement de la position initiale à la position de déformation et inversement.

6. Dispositif d'opération (1) selon la revendication 5, **caractérisé en ce que** l'élément (16) à élasticité de ressort est une rondelle à déclic courante.

7. Dispositif d'opération (1) selon l'une des revendications précédentes 5 ou 6, **caractérisé en ce que** l'élément (16) à élasticité de ressort est guidé dans la direction de son mouvement (T) par au moins une paroi (102) du boîtier (10).

8. Dispositif d'opération (1) selon l'une des revendications précédentes 5 à 7, **caractérisé en ce que** l'élément d'opération (11) est guidé dans sa direction d'actionnement (B) par au moins une paroi (101) du boîtier (10).

9. Dispositif d'opération (1) selon l'une des revendications précédentes 5 à 8, **caractérisé en ce que** l'interface d'opération (12) de l'élément d'opération (11) est réalisée sous la forme d'une surface sensible à l'approche et/ou tactile et un appareil d'interprétation et de commande (20) est présent, par lequel peut être détectée la position de laquelle s'approche un outil d'opération d'un opérateur sur l'interface d'opération (12) ou la position que celui-ci touche.

10. Dispositif d'opération (1) selon la revendication 9, **caractérisé en ce que** plusieurs symboles d'opération (13) sont disposés sur l'interface d'opération (12) et l'interface d'opération (12) est réalisée sous la forme d'une surface continue.

11. Véhicule automobile (K), **caractérisé par** au moins un dispositif d'opération (1) selon l'une des revendications précédentes 5 à 10.
